# EUROPÄISCHE PATENTANMELDUNG

(11) **EP 2 572 921 A1**
(43) Veröffentlichungstag der Anmeldung: **27.03.2013**
(21) Anmeldenummer: 11182737.4
(22) Anmeldetag: 26.09.2011
(51) Int. Cl.: B60L 3/00, G01R 31/02

(54) **Schaltkreisüberwachung**

(71) Anmelder: Siemens Aktiengesellschaft, 80333 München (DE)
(72) Erfinder: Köpken, Hans-Georg, 91056 Erlangen (DE)
(74) Vertreter: Aspacher, Karl-Georg

(57) **Zusammenfassung**

Die Erfindung gibt ein Verfahren zum Überwachen einer Schaltung (2) aus einer Batterie (4) und einem an die Batterie (4) angeschlossenen elektrischen Verbraucher (6) an. Das angegebene Verfahren umfasst Variieren (38) eines elektrischen Leistungsflusses zwischen der Batterie (4) und dem elektrischen Verbraucher (6), Erfassen (40, 46) einer Reaktion der Schaltung (2) auf die Variation (38) und Bestimmen (44) eines Fehlers (34), wenn die erfasste Reaktion von einer vorbestimmten Reaktion abweicht.

## Beschreibung

Die Erfindung betrifft ein Verfahren zum Überwachen einer Schaltung aus einer Batterie und einem an die Batterie angeschlossenen elektrischen Verbraucher und eine Vorrichtung zur Durchführung des Verfahrens.

In Schaltungen, die in nicht stationären, beweglichen Vorrichtungen, wie beispielsweise einem Fahrzeug, untergebracht sind, werden in der Regel elektrische Verbraucher über eine Batterie mit elektrischer Energie versorgt. Dazu werden der elektrische Verbraucher und die Batterie zu einer Schaltung verbaut.

Ist in der Schaltung der leistungsführende Schaltkreis aus der Batterie und dem elektrischen Verbraucher fehlerhaft unterbrochen, kann er durch eine unbeabsichtigte Berührung beispielsweise durch Personen über einen Erdschluss geschlossen werden. Je nach Höhe der durch die Batterie abgegebenen Spannung können hier lebensgefährliche Ableitströme durch die berührende Person in Form von Körperströmen fließen. Sind im leistungsführenden Schaltkreis zwischen dem elektrischen Verbraucher und der Batterie ferner Zwischenspeicher, wie ein Zwischenkreiskondensator enthalten, müssen diese beispielsweise für Wartungszwecke beziehungsweise bei der Beseitigung von Fehlern nach dem Unterbrechen des leistungsführenden Schaltkreises aus Sicherheitsgründen entladen werden, damit beim Wartungspersonal bei Berührung des Zwischenspeichers keine gefährlichen Körperströme zum Fließen gebracht werden.

Daher muss der leistungsführende Schaltkreis hinsichtlich Unterbrechungen überwacht werden.

Aus der DE 10 2009 020 178 A1 ist eine entsprechende Schaltkreisüberwachung bekannt. Dabei wird der leistungsführende Schaltkreis mittels sogenannter Pilotlines oder Hochvolt Interlocks überwacht. Hierbei handelt es sich um einen elektrisch redundanten Schaltkreis, der parallel zum leistungsführenden Schaltkreis geführt ist. Ist der redundante Schaltkreis geöffnet, so kann davon ausgegangen werden, dass auch der leistungsführende Schaltkreis geöffnet ist.

Es ist Aufgabe die bekannte Schaltkreisüberwachung zu verbessern.

Die Aufgabe wird durch die Merkmale der unabhängigen Ansprüche gelöst. Bevorzugte Weiterbildungen sind Gegenstand der abhängigen Ansprüche.

Die Erfindung schlägt vor, basierend auf einer Variation des Leistungsflusses durch den Schaltkreis aus der Batterie und dem elektrischen Verbraucher und einer Reaktion der Schaltung mit der Batterie und dem elektrischen Verbraucher herauszufinden, ob der Schaltkreis unterbrochen ist.

Der Vorschlag basiert auf der Erkenntnis, dass bei einem geschlossenen leistungsführenden Schaltkreis Änderungen des Leistungsflusses zu plausiblen Reaktionen in der Schaltung führen müssen. Mit anderen Worten muss eine definierte Änderung des Leistungsflusses zwischen der Batterie und dem elektrischen Verbraucher zu einer überprüfbaren Reaktion der Schaltung führen, wenn der Schaltkreis zwischen Batterie und elektrischem Verbraucher geschlossen ist.

Der Überlegung der Erfindung ist daher, eine definierte Änderung des Leistungsflusses festzulegen und die überprüfbare Reaktion zunächst beispielsweise rechnerisch zu bestimmen. Dann kann erfindungsgemäß in der Schaltung überprüft werden ob die überprüfbare Reaktion tatsächlich eintritt.

Die Erfindung gibt daher ein Verfahren zum Überwachen einer Schaltung mit einer Batterie und einem an die Batterie angeschlossenen elektrischen Verbraucher an. Das angegebene Verfahren umfasst Variieren eines elektrischen Leistungsflusses zwischen der Batterie und dem elektrischen Verbraucher, Erfassen einer Reaktion der Schaltung auf die Variation und Bestimmen eines Fehlers, wenn die erfasste Reaktion von einer vorbestimmten Reaktion abweicht.

Als Reaktion können alle beliebigen elektrischen und physikalischen Größen in der Schaltung herangezogen werden, die vom Leistungsfluss zwischen der Batterie und dem elektrischen Verbraucher abhängen. Dies können beispielsweise die Werte des Gesamtwiderstands oder des Arbeitspunktes der Schaltung sein. Aber auch andere physikalische Größen, wie eine Wärmeentwicklung oder eine Störabstrahlung können zur erfindungsgemäßen Überwachung des Schaltkreises zwischen der Batterie und dem elektrischen Verbraucher herangezogen werden.

Durch das angegebene Verfahren können Unterbrechungen des Schaltkreises zwischen der Batterie und dem elektrischen Verbraucher festgestellt werden, ohne dass ein zusätzlicher redundanter Schaltkreis, wie beispielsweise eine Pilotline beziehungsweise ein Hochvolt Interlock notwendig ist. Diese Elemente sind damit überflüssig und können vollständig weggelassen werden. Folglich reduziert die Erfindung die Herstellungskosten und die Baugrößen entsprechender Schaltungen.

Darüber hinaus kann das angegebenen Verfahren den Schaltkreis der Schaltung auch hinsichtlich einer wesentlich breiteren Anzahl an Fehlerquellen überwachen, da die Reaktion der Schaltung auf eine Variation des Leistungsflusses nicht nur im Falle einer Unterbrechung des Schaltkreises sondern auch im Falle anderer Fehler von der vorbestimmten Reaktion abweicht. Diese Fehler können beispielsweise Kurzschlüsse im Schaltkreis aber auch Bauteildrifteffekte sein, die altersbedingt beispielsweise an der Batterie oder dem elektrischen Verbraucher auftreten.

In einer Weiterbildung der Erfindung erfolgt die Variation des elektrischen Leistungsflusses mit einem bestimmten Muster. Dieses Muster ist beispielsweise mittels eines Signalgenerators nicht nur in einfacher erzeugbar, das Muster lässt sich auch problemlos an die Rahmenbedingungen der Schaltung anpassen, so dass die Schaltung durch die Variation des Leistungsflusses beispielsweise nicht in kritische Betriebszustände überführt wird, die die Schaltung schädigen oder gar zerstören können.

In einer zusätzlichen Weiterbildung umfasst das angegebene Verfahren den Schritt Erfassen einer die Schaltung beschreibenden elektrischen Größe und Suchen des Musters in der erfassten elektrischen Größe. Der Weiterbildung liegt der Gedanke zugrunde, dass im Falle von Unterbrechungen und Kurzschlüssen im Schaltkreis zwischen der Batterie und dem elektrischen Verbraucher keine elektrischen Leistungen übertragbar sind. Folglich führt eine Variation des Leistungsflusses auch zu keiner Reaktion des Schaltkreises. Das Muster kann daher nur dann in der Reaktion der Schaltung wiederzufinden sein, wenn die Schaltung frei von Unterbrechungen und Kurzschlüssen ist. Auf diese Weise lässt sich die Verifikation, ob die gemessene Reaktion von der vorbestimmten Reaktion abweicht, in besonders einfacher Weise durchführen, da die vorbestimmte Reaktion durch das verwendete Muster bereits bekannt ist und nicht erst definiert werden muss.

In einer bevorzugten Weiterbildung ist das Muster eine zyklische Variation des elektrischen Leistungsflusses. Die zyklische Variation kann jede beliebige Form, wie beispielsweise eine Sinus-Form oder eine pseudozufällige Form annehmen. Durch die Verwendung einer zyklischen Variation des Leistungsflusses kann die Suche nach dem Muster technisch besonders einfach umgesetzt werden, da die vorbestimmte Reaktion der Schaltung spektral begrenzt ist.

In einer besonders bevorzugten Weiterbildung umfasst das angegebene Verfahren den Schritt Korrelieren der elektrischen Größe mit dem zyklischen elektrischen Leistungsfluss zum Suchen des Musters. Durch die Korrelation können effizient störende Signale wie Rauschanteile in der erfassten Reaktion gefiltert werden. Zudem ist das Verfahren dieser Weiterbildung in einfacher Weise mit bekannten Schaltungselementen, wie beispielsweise einem Lock-in-Verstärker umsetzbar, die kostengünstig und erprobt erhältlich sind.

In einer anderen Ausführung umfasst das angegebene Verfahren den Schritt Ansteuern eines Schalters eines elektrischen Wandlers zur Variation des elektrischen Leistungsflusses, wobei der elektrische Wandler zum Umwandeln einer von der Batterie abgegebenen und an den elektrischen Verbraucher übertragenen elektrischen Leistung vorgesehen ist. Der elektrische Wandler ist in zahlreichen Applikation beispielsweise in Form eines Wechselrichters vorhanden. Seine Ansteuerung geschieht in der Regel rein elektronisch beispielsweise durch eine auf einem Ansteuerrechner ablaufende Ansteuersoftware. Diese Ansteuersoftware kann durch geeignete Modifikationen zur praktischen Umsetzung des angegebenen Verfahrens mitgenutzt werden, so dass keine zusätzlichen mechanischen oder anderweitigen strukturellen Gestaltungsmaßnahmen an der Schaltung notwendig sind, um die Erfindung zu realisieren. Überraschender Weise erlaubt es die angegebene Ausführung auch, herkömmliche, bereits existierende Schaltungen mit einem elektrischen Wandler aber ohne Pilotlines beziehungsweise Hochvolt Interlocks mit einer Sicherungsfunktion auszustatten, die die Schaltung auf Unterbrechungen oder andere Fehler, wie beispielsweise Kurzschlüsse hin überwacht.

In einer weiteren Ausführung der Erfindung umfasst das angegebene Verfahren den Schritt Entladen einer Kapazität basierend auf der Fehlermeldung, wobei die Kapazität vorgesehen ist, zwischen der Batterie und dem elektrischen Verbraucher übertragene elektrische Energie zwischenzuspeichern. Die energiespeichernde Kapazität kann insbesondere im Falle von Unterbrechungen in der Schaltung ein Sicherheitsrisiko darstellen, da sie gefährliche Spannungen führt, die sich wie eingangs erwähnt bei Berührung beispielsweise durch Personen über diese entladen können. Durch das angegebene Verfahren kann dieses Sicherheitsrisiko nicht nur erkannt sondern auch wirksam minimiert werden.

In einer Ausbildung der Erfindung umfasst das angegebene Verfahren den Schritt Bestimmen des Fehlers, wenn eine Schwankung der erfassten elektrischen Größe außerhalb eines vorbestimmten Bereichs für die Schwankung fällt. Der vorbestimmte Bereich für die Schwankung kann beispielsweise durch wenige Schwellenwerte vorgegeben werden, so dass die Fehlerbestimmung direkt mit einer Messgröße ohne weitere Signalumformungen durchführbar werden kann.

In einer weiterführenden Ausbildung umfasst der vorbestimmte Bereich für die Schwankung einen Wert der elektrischen Größe, bei dem die Batterie einen elektrischen Prüfverbraucher, insbesondere einem Zwischenkreiskondensator, zwischen der Batterie und dem elektrischen Verbraucher mit elektrischer Energie speist. Dieser Ausbildung liegt die Überlegung zugrunde, dass im fehlerfreien Fall der Zwischenkreiskondensator von der Batterie mit elektrischer Energie versorgt wird. Im Unterbrechungsfall zur Batterie übernimmt der Zwischenkreiskondensator die elektrische Energieversorgung des Verbrauchers, was zu starken Schwankungen der Spannung am Zwischenkreiskondensator führt. Im Kurzschlussfall jedoch schwankt die Spannung am Zwischenkreiskondensator überhaupt nicht mehr, da auch der Zwischenkreiskondensator im Kurschlussfall keine elektrischen Leistungen mehr übertragen kann. Auf diese Weise kann eine Unterbrechung nicht nur erkannt sondern auch von einem Kurzschluss unterschieden werden.

In einer anderen Ausbildung der Erfindung umfasst das angegebene Verfahren den Schritt Erfassen einer Impedanz der Schaltung und Bestimmen des Fehlers, wenn die Impedanz außerhalb eines vorbestimmten Bereichs fällt. Die zur Impedanzbe-rech¬nung notwendigen elektrischen Größen können in der Schaltung an einer beliebigen Stelle erfasst werden. Dies ist insbesondere für den Fall vorteilhaft, dass ein bereits erwähnter elektrischer Wandler eingesetzt wird, da seine Messwerterfassung zur Umsetzung des Verfahrens herangezogen werden kann, ohne dass die Schaltung strukturell verändert werden muss.

In einer bevorzugten Ausführung umfasst der vorbestimmte Bereich eine Impedanz, die einen Wert der Impedanz aus einer Zusammenschaltung der Batterie und des elektrischen Verbrauchers aufweist. Die Impedanz des vorbestimmten Bereichs kann damit den fehlerfreien Fall charakterisieren, wobei der Bereich beliebig mit Toleranzen behaftet werden kann, um eine ungewollte Erzeugung eines Fehlers zu vermeiden.

In einer besonders bevorzugten Ausbildung der Erfindung ist aus dem Bereich eine Impedanz ausgeschlossen, die einen Wert der Impedanz der Batterie und/oder einen Wert des elektrischen Verbrauchers aufweist. Auf diese Weise können die Fehler, dass eine Unterbrechung zwischen Messinstrument und Batterie oder eine Unterbrechung zwischen Messinstrument und elektrischem Verbraucher vorliegt, ganz konkret bestimmt und im angegebenen Verfahren berücksichtigt werden.

Die Erfindung gibt auch eine Vorrichtung an, die einen Speicher zum Speichern eines Programmcodes zur Ausführung eines angegebenen Verfahrens und einen Prozessor zum Ausführen des Programmcodes, wenn der Programmcode aus dem Speicher geladen ist, umfasst.

Die Erfindung gibt auch eine Schaltung an, die eine Batterie, einen elektrischen Verbraucher, einen elektrischen Wandler zum Speisen des elektrischen Verbrauchers mit der elektrischen Energie aus der Batterie und eine angegebene Vorrichtung umfasst.

Die Erfindung gibt auch ein Fahrzeug an, das eine angegebene Schaltung umfasst, wobei der elektrische Verbraucher ein elektrischer Motor im Fahrzeug ist.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung des Ausführungsbeispiels, die im Zusammenhang mit den Zeichnungen näher erläutert werden, wobei:
- FIG 1: eine Schaltung mit einer an die Schaltung angeschlossenen Vorrichtung gemäß der Erfindung,
- FIG 2: eine Detaildarstellung des Netzwerks aus FIG 1,
- FIG 3: ein erstes Ausführungsbeispiel gemäß der Erfindung und
- FIG 4: ein zweites Ausführungsbeispiel gemäß der Erfindung zeigen.

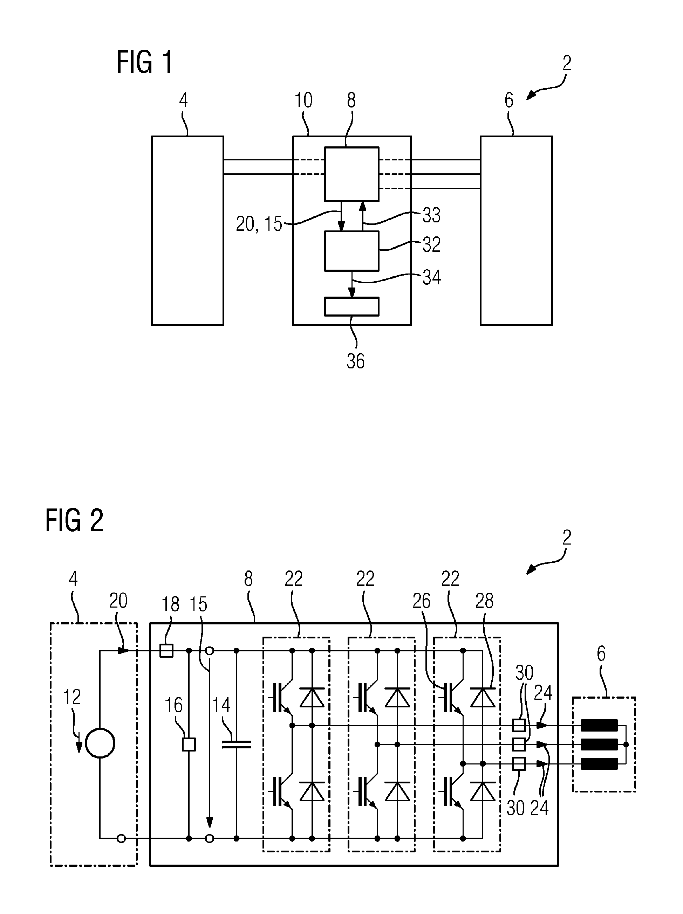

Es wird auf die FIG 1 und 2 Bezug genommen.

In einer Schaltung 2 sind eine Batterie 4 und ein elektrischer Verbraucher in Form eines dreiphasigen Elektromotors 6 über einen elektrischen Wandler in Form eines dreiphasigen Wechselrichters 8 miteinander elektrisch verbunden. Der dreiphasige Wechselrichter 8 ist in einer Inverterbox 10 aufgenommen. Die Schaltung 2 kann beispielsweise Teil eines Bordnetzes eines nicht gezeigten Fahrzeuges sein, in der die Batterie 4 als wiederaufladbarer Akkumulator den dreiphasigen Elektromotor 6 als Antriebseinheit des Fahrzeugs mit elektrischer Energie versorgt.

Über die Batterie 4 ist an den Wechselrichter 8 eine Batteriespannung 12 angelegt. Im Wechselrichter 8 ist ein Zwischenkreiskondensator 14 parallel zur Batterie 4 geschaltet, der durch die Batteriespannung 12 auf die Batteriespannung 12 aufgeladen ist. Die Kondensatorspannung 15 kann durch einen Spannungsmesser 16 erfasst werden, der parallel zum Zwischenkreiskondensator 12 geschaltet ist. Zusätzlich kann im Strompfad zwischen der Batterie 4 und dem Zwischenkreiskondensator 12 ein Strommesser 18 angeordnet sein, der den von der Batterie 4 abgegebenen elektrischen Batteriestrom 20 erfasst.

Der Wechselrichter 8 umfasst drei Halbbrücken 22, die je eine Wechselstromphase 24 für den dreiphasigen Elektromotor 6 basierend auf dem Batteriestrom 20 erzeugen. Jede Halbbrücke 22 weist zwei in Reihe geschaltete Schaltelemente, wobei jedes Schaltelement aus einem Schalter 26, wie beispielsweise einem IGBT (Bipolartransistor mit isolierter Gateelektrode) und einer dazu parallel geschalteten Freilaufdiode 28 besteht. Der Übersichtlichkeit halber ist in FIG 2 nur ein Schalter 26 und eine Freilaufdiode 28 mit einem Bezugszeichen versehen.

Die Höhe der Ströme in den Wechselstromphasen 24 können mit einem entsprechenden Phasenstrommesser 30 gemessen werden. Da die Summe der Messwerte aus den Phasenstrommessern 30 Null ergibt kann eine der Wechselstromphasen 24 rechnerisch bestimmt und gegebenenfalls auf einen der Phasenstrommesser 30 verzichtet werden.

Der erfasste Batteriestrom 20 sowie die erfasste Kondensatorspannung 15, die der Batteriespannung 12 entspricht, werden einer Vorrichtung 32 in der Inverterbox 10 zum Überwachen der Schaltung 2 bereitgestellt. Die Vorrichtung 32 ist ferner vorgesehen, basierend auf Ansteuersignalen 33 die Schalter 26 des Wechselrichters 8 anzusteuern. In der vorliegenden Ausführungsform überprüft die Vorrichtung 32 basierend auf dem erfassten Batteriestrom 20 sowie der erfassten Kondensatorspannung 15 in einer noch zu beschreibenden Weise, ob der Schaltkreis aus der Batterie 4 und dem Elektromotor 6 in der Schaltung 2 fehlerhaft ist und beispielsweise Unterbrechungen oder Kurzschlüsse aufweist. Gegebenenfalls gibt die Vorrichtung 32 eine entsprechende Fehlermeldung 34 aus. In der vorliegenden Ausführung wird mit der Fehlermeldung 34 eine Sicherungsfunktion 36 angesteuert, die den Zwischenkreiskondensator 14 in einer nicht gezeigten Weise entlädt.

Nachstehend wird anhand zweier Ausführungsbeispiele erläutert, wie die Vorrichtung 32 die Fehlermeldung 34 bestimmt.

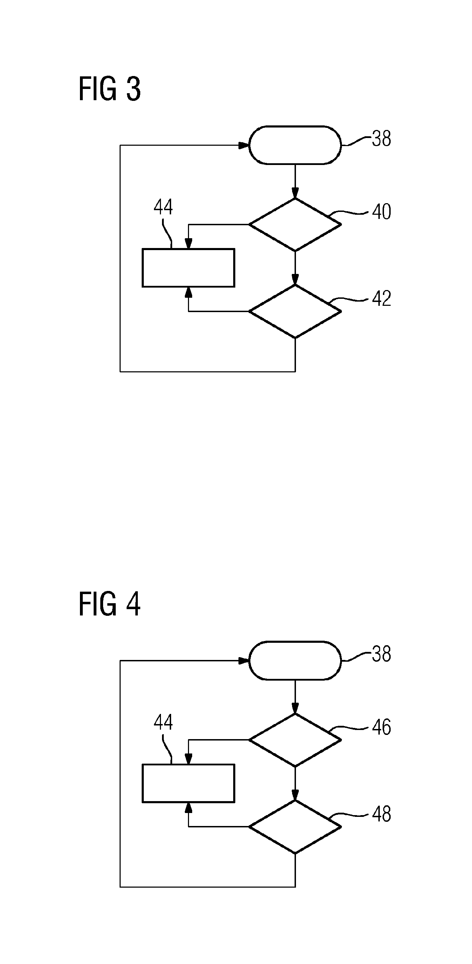

FIG 3 zeigt ein erstes Ausführungsbeispiel zum Bestimmen der Fehlermeldung 34 mit der Vorrichtung 32.

Zunächst variiert die Vorrichtung 32 in Schritt 38 mittels des Steuersignals 33 den Leistungsfluss durch die Schaltung 2 zyklisch, so dass in der Schaltung 2 ein vergleichsweise kleiner Wechselstrom überlagert wird, dessen Spitze-zu-Spitze Wert beispielsweise 1% des Batteriestromes betragen kann.

In Schritt 40 empfängt die Vorrichtung die Kondensatorspannung 15, die vom Spannungsmessgerät 16 erfasst wird und überprüft, ob in der Kondensatorspannung 15 ein dem variierten Leistungsfluss äquivalentes Muster zu finden ist. Dazu kann die Vorrichtung 32 beispielsweise das zur Variation des Leistungsflusses verwendete Muster mit der erfassten Kondensatorspannung 15 korrelieren. Zur Korrelation kann die Kondensatorspannung 15 mit dem Muster multipliziert und anschließend tiefpassgefiltert werden. Findet sich das Muster in der Kondensatorspannung 15 als Ergebnis der Korrelation, so ist das ein Hinweis darauf, dass elektrische Leistung zum Elektromotor 6 übertragen wird und kein Kurzschluss vorhanden sein kann. In diesem Fall führt die Vorrichtung 32 das Verfahren mit Schritt 42 fort. Alternativ gibt die Vorrichtung 32 in Schritt 44 eine Fehlermeldung 36 aus.

In Schritt 42 überprüft die Vorrichtung 32, wie hoch die Schwankungen im gefundenen Muster der Kondensatorspannung 15 sind. Überschreiten die Schwankungen einen bestimmten Schwellenwert, so ist das ein Hinweis darauf, dass allein der Zwischenkreiskondensator 14 die elektrische Energie für den Elektromotor 6 bereitstellt und eine Unterbrechung zwischen Batterie 4 und Zwischenkreiskondensator 14 vorhanden sein muss. In diesem Fall gibt die Vorrichtung 32 in Schritt 44 die Fehlermeldung 36 aus. Bleiben die Schwankungen unterhalb des Schwellenwertes, so bestimmt die Vorrichtung 32, dass der Funktionszustand der Schaltung 2 fehlerfrei ist und startet das Verfahren erneut mit Schritt 38.

FIG 4 zeigt ein zweites Ausführungsbeispiel zum Bestimmen der Fehlermeldung 34 mit der Vorrichtung 32. In FIG 4 werden zu FIG 3 gleiche Schritte mit gleichen Bezugszeichen versehen und nicht noch einmal beschrieben.

In FIG 4 ist der Schritt 40 durch den Schritt 46 und der Schritt 42 durch den Schritt 48 ersetzt.

Während im Schritt 40 in der erfassten Kondensatorspannung 15 das Muster der Variation des Leistungsflusses gesucht wurde, empfängt die Vorrichtung 32 neben der Kondensatorspannung im Schritt 46 den Batteriestrom 20 und berechnet die Impedanz des Stromkreises zwischen dem Zwischenkreiskondensator 14 und der Batterie 4. Die berechnete Impedanz wird gegen einen unteren Schwellenwert verglichen. Ist die berechnete Impedanz zu niedrig, so ist das ein Hinweis auf einen Kurzschluss im Stromkreis zwischen dem Zwischenkreiskondensator 14 und der Batterie 4 und das Verfahren gibt entsprechend in Schritt 44 die Fehlermeldung 34 aus.

Andernfalls wird mit Schritt 48 weiter verfahren, in dem die berechnete Impedanz gegen einen oberen Schwellenwert verglichen wird. Ist die berechnete Impedanz zu hoch, so ist das ein Hinweis auf eine Unterbrechung im Stromkreis zwischen dem Zwischenkreiskondensator 14 und der Batterie 4. Das Verfahren gibt in diesem Fall ebenfalls die Fehlermeldung 34 in Schritt 44 aus. Wenn die berechnete Impedanz zwischen dem unteren und oberen Schwellenwert liegt, so ist der Funktionszustand der Schaltung 2 fehlerfrei und das Verfahren startet erneut mit Schritt 38.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Überwachen einer Schaltung (2) aus einer Batterie (4) und einem an die Batterie (4) angeschlossenen elektrischen Verbraucher (6), umfassend Variieren (38) eines elektrischen Leistungsflusses zwischen der Batterie (4) und dem elektrischen Verbraucher (6), Erfassen (40, 46) einer Reaktion der Schaltung (2) auf die Variation (38) und Bestimmen (44) eines Fehlers (34), wenn die erfasste Reaktion von einer vorbestimmten Reaktion abweicht.

2. Verfahren nach Anspruch 1, wobei die Variation (38) des elektrischen Leistungsflusses mit einem bestimmten Muster erfolgt.

3. Verfahren nach Anspruch 2 umfassend Erfassen einer die Schaltung (2) beschreibenden elektrischen Größe (15) und Suchen (46) des Musters in der erfassten elektrischen Größe (15).

4. Verfahren nach Anspruch 3, wobei das Muster eine zyklische Variation des elektrischen Leistungsflusses ist.

5. Verfahren nach Anspruch 3 oder 4 umfassend Korrelieren der elektrischen Größe mit dem zyklischen elektrischen Leistungsfluss zum Suchen des Musters.

6. Verfahren nach einem der vorstehenden Ansprüche umfassend Ansteuern eines Schalters (26) eines elektrischen Wandlers (8) zur Variation des elektrischen Leistungsflusses, wobei der elektrische Wandler (8) zum Umwandeln einer von der Batterie (4) abgegebenen und an den elektrischen Verbraucher (6) übertragenen elektrischen Leistung vorgesehen ist.

7. Verfahren nach einem der vorstehenden Ansprüche umfassend Entladen (36) einer Kapazität (14) basierend auf der Fehlermeldung (34), wobei die Kapazität (14) vorgesehen ist, zwischen der Batterie (4) und dem elektrischen Verbraucher (6) übertragene elektrische Energie zwischenzuspeichern.

8. Verfahren nach einem der Ansprüche 3 bis 7, umfassend Bestimmen (40) des Fehlers (34), wenn eine Schwankung der erfassten elektrischen Größe (15) außerhalb eines vorbestimmten Bereichs für die Schwankung fällt.

9. Verfahren nach Anspruch 8, wobei der vorbestimmte Bereich für die Schwankung einen Wert der elektrischen Größe (15) umfasst, bei dem die Batterie (4) einen elektrischen Prüfverbraucher, insbesondere einem Zwischenkreiskondensator (15), zwischen der Batterie (4) und dem elektrischen Verbraucher (6) mit elektrischer Energie speist.

10. Verfahren nach einem der vorstehenden Ansprüche, umfassend Erfassen (46) einer Impedanz der Schaltung und Bestimmen des Fehlers, wenn die Impedanz außerhalb eines vorbestimmten Bereichs fällt.

11. Verfahren nach Anspruch 10, wobei der vorbestimmte Bereich eine Impedanz umfasst, die einen Wert der Impedanz aus einer Zusammenschaltung der Batterie (4) und des elektrischen Verbrauchers (6) aufweist.

12. Verfahren nach Anspruch 10 oder 11, wobei aus dem Bereich eine Impedanz ausgeschlossen ist, die einen Wert der Impedanz der Batterie (4) und/oder einen Wert des elektrischen Verbrauchers (6) entspricht.

13. Vorrichtung (32) umfassend einen Speicher zum Speichern eines Programmcodes zur Ausführung eines Verfahrens nach einem der vorstehenden Ansprüche und einen Prozessor zum Ausführen des Programmcodes, wenn der Programmcode aus dem Speicher geladen ist.

14. Schaltung (2) umfassend eine Batterie (4), einen elektrischen Verbraucher (6), einen elektrischen Wandler (8) zum Speisen des elektrischen Verbrauchers mit der elektrischen Energie aus der Batterie (4) und eine Vorrichtung (32) nach Anspruch 13.

15. Fahrzeug umfassend eine Schaltung (2) nach Anspruch 14, wobei der elektrische Verbraucher (6) ein elektrischer Motor im Fahrzeug ist.
